# EUROPEAN PATENT SPECIFICATION

(11) **EP 1 009 588 B1**
(45) Date of publication and mention of the grant of the patent: **19.02.2003**
(21) Application number: 97945409.7
(22) Date of filing: 30.09.1997
(51) Int. Cl.: B24B 37/04, B24D 11/00

(54) **POLISHING PAD AND METHOD FOR MAKING POLISHING PAD WITH ELONGATED MICROCOLUMNS**
POLIERKISSEN UND VERFAHREN ZUM HERSTELLEN VON POLIERKISSEN MIT LANGGESTRECKTEN MIKROSÄULEN
TAMPON DE POLISSAGE ET PROCEDE DE FABRICATION DE TAMPON DE POLISSAGE A MICROCOLONNES ALLONGEES

(30) Priority: 30.09.1996 US 723901
(43) Date of publication of application: 21.06.2000
(73) Proprietor: MICRON TECHNOLOGY, INC., Boise, ID 83707-0006 (US)
(72) Inventor: DOAN, Trung, Tri, Boise, ID 83712 (US); MEIKLE, Scott, G., Boise, ID 83712 (US)
(74) Representative: Hirsch, Peter, Dipl.-Ing.
(86) International application number: PCT/US97/17679
(87) International publication number: WO 98/014304

(56) References cited:
- EP-A- 0 593 057
- EP-A- 0 737 547
- US-A- 5 329 734
- US-A- 5 533 923
- US-A- 5 584 146

## Description

### Technical Field

The present invention relates to polishing pads as per the preamble of claims 1 or 2 and a method for making the same as per the preamble of claim 9. An example of such pad and method are disclosed in US 5 533 923 A.

### Background of the Invention

Chemical-mechanical planarization ("CMP") processes remove materials from the surface layer of a wafer in the production of ultra-high density integrated circuits. In a typical CMP process, a wafer presses against a polishing pad in the presence of a slurry under controlled chemical, pressure, velocity, and temperature conditions. The slurry solution has abrasive particles that abrade the surface of the wafer, and chemicals that oxidize and/or etch the surface of the wafer. Thus, when relative motion is impaired between the wafer and the pad, material is removed from the surface of the wafer by the abrasive particles (mechanical removal) and by the chemicals in the slurry (chemical removal).

CMP processes must consistently and accurately produce a uniform, planar surface on the wafer because it is important to accurately focus optical or electromagnetic circuit patterns on the surface of the wafer. As the density of integrated circuits increases, it is often necessary to accurately focus the critical dimensions of the photo-pattern to within a tolerance of approximately 0.5 µm. Focusing the photo-patterns to such small tolerances, however, is very difficult when the distance between the emission source and the surface of the wafer varies because the surface of the wafer is not uniformly planar. In fact, several devices may be defective on a wafer with a non-uniform surface. Thus, CMP processes must create a highly uniform, planar surface.

In the competitive semiconductor industry, it is also desirable to maximize the throughput of the finished wafers and minimize the number of defective or impaired devices on each wafer. The throughput of CMP processes is a function of several factors, one of which is the rate at which the thickness of the wafer decreases as it is being planarized (the "polishing rate") without sacrificing the uniformity of the planarity of the surface of the wafer. Accordingly, it is desirable to maximize the polishing rate within controlled limits.

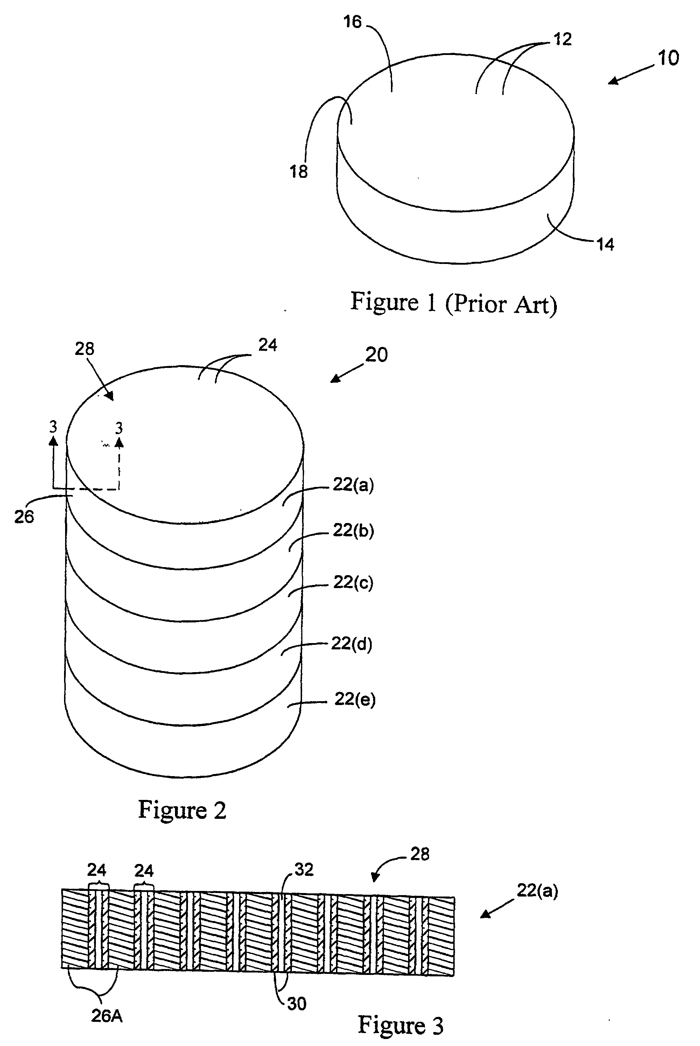

One problem with current CMP processes is that the polishing rate varies over a large number of wafers because certain structural features on the planarizing surface of the pad vary over the life of a pad. One such structural feature is the non-uniformity of the distribution of filler material throughout the pad. Prior art polishing pads typically are made from a mixture of a continuous phase polymer material, such as polyurethane, and a filler material, such as hollow spheres. Shown in Figure 1 is a prior art polishing pad 10 having spheres 12 embedded in a polymeric matrix material 14. As can be seen, the spheres 12 have agglomerated into sphere clusters 16 before the matrix material 14 fully cured, resulting in a non-uniform distribution of the spheres 12 in the matrix material 14. Consequently, regions on the planarizing surface 18 of the polishing pad 10 at the sphere clusters 16 have a high polishing rate, while regions that lack spheres have a conversely low polishing rate. In addition, when using such a polishing pad 10 in a CMP process, the planarizing surface 18 is periodically removed to expose a fresh planarizing surface. The density of sphere clusters 16 vary throughout the thickness of the polishing pad 10, thereby causing the polishing pad 10 to exhibit different polishing characteristics as layers of planarizing surfaces are removed. Although many efforts have been made to provide uniform porosity throughout the continuous phase material, many pads still have a non-uniform porosity on their planarizing surface. Moreover, the non-uniform areas of the pad are not visibly distinguishable from other areas on the pad, making it difficult to detect and discard unacceptable pads.

### Summary of the Invention

One aspect of the present invention is directed to a CMP polishing pad having elongated microcolumns positioned within a matrix body as per claim 1 or claim 2. All of the embodiments preferably distribute the elongated microcolumns uniformly through the polishing pad, resulting in a polishing pad with uniform polishing properties throughout.

A second aspect of the invention is directed to a method of making a CMP polishing pad for planarizing semiconductor wafers as per claim 9. In an embodiment, a first set of the microcolumns made of a first material are interspersed with a second set of microcolumns made of a second material. The method exposes the pad body to a solvent material that removes the first material without removing the second material and the matrix material, and thereby creates elongated pores between the microcolumns of the second set.

The microcolumns may be maintained in their parallel position by positioning the microcolumns within the mold as a bundle in which a connecting piece holds the microcolumns together. After the matrix material has cured, the connecting piece is detached from the microcolumns. Alternatively, the microcolumns can be maintained in a parallel orientation by extending the microcolumns through spaced-apart apertures in an alignment fixture with each microcolumn extending through a separate aperture.

### Brief Description of the Drawings

Figure 1 is an isometric view of a prior art CMP polishing pad.
Figure 2 is an isometric view of a cake of polishing pad material.
Figure 3 is a partial cross-sectional view of a polishing pad taken along line 3-3 of Figure 2.
Figure 4 is a partial cross-sectional view of an alternate polishing pad.
Figure 5 is a partial cross-sectional view of an embodiment of polishing pad according to the present invention.
Figure 6 is an elevational view of a polishing pad with grooves.
Figure 7 is a flow diagram of a method for making a polishing pad.
Figure 8 is an isometric view of elongated microcolumns being inserted into a polishing pad cake mold.
Figure 9 is a cross-sectional view of an alignment fixture maintaining spacing between elongated microcolumns.

### Detailed Description of the Invention

One aspect of the present invention is directed to a CMP polishing pad having elongated microcolumns positioned within a matrix body as per claim 1 or claim 2. The microcolumns are uniformly distributed throughout the polishing pad, resulting in uniform properties throughout the pad. In particular, the polishing pad is uniformly abrasive and porous throughout the planarizing surface of the polishing pad such that the polishing pad achieves a uniform polishing rate across the planarizing surface. In addition, the polishing rate achievable by the polishing pad remains stable throughout the life of the polishing pad. Further, the elongated microcolumns provide a polishing pad with more uniform porosity than the prior art polishing pads which results in a more uniform and stable polish of the semiconductor wafers.

Shown in Figure 2 is a polishing pad cake 20 from which a plurality of individual polishing pads 22(a)-22(e) are cut. The cake 10 includes a multiplicity of elongated microcolumns 24 embedded in a matrix material 26. The elongated microcolumns can be made of almost any substantially rigid material, such as fiberglass, silicon dioxide, or various polymeric materials. The matrix material 26 can be any polymeric material, such as polyurethane or nylon. The elongated microcolumns 24 extend inwardly from a flat planarizing surface 28 for planarizing the semiconductor wafers. The elongated microcolumns 24 preferably are uniformly straight and sufficiently rigid to remain parallel to each other substantially along the entire length of the microcolumns. The ability to maintain such a parallel orientation enables the elongated microcolumns 24 to be uniformly distributed throughout the entire polymer pad cake 20.

A partial cross-sectional view of the polishing pad 22(a), which does not form subject-matter of the current invention, is shown in Figure 3. As can be seen, each of the elongated microcolumns 24 is hollow such that each microcolumn has an outer support tube 30 surrounding an elongated pore 32. The elongated microcolumns 24, including the elongated pores 32 within the microcolumns 24, extend entirely through the polishing pad 22(a) and perpendicular to the planarizing surface 28. Alternatively, the elongated microcolumns 24 could be made to extend from the planarizing surface 28 through the polishing pad 22(a) less than the full distance. Either way, the elongated pores 32 enable liquid used in the CMP process to be absorbed and distributed by the polishing pad 22(a). The liquid can be part of a chemical slurry that also includes abrasive particles or the microcolumns can be made abrasive so that the liquid is not part of a slurry. Because the elongated microcolumns 24 are distributed substantially uniformly across the planarizing surface 28, the porosity of the polishing pad 22(a) is substantially uniform across the entire planarizing surface 28. The uniform porosity provided by the uniformly distributed elongated pores 32 enables the polishing pad 22(a) to planarize the semiconductor wafers substantially uniformly across the planarizing surface 28.

The polishing pad 22(a) can be made by embedding in the matrix material 26 elongated microcolumns that are already hollow, and thus, already include the elongated pores 32. Alternatively, the hollow elongated microcolumns 24 can be made by using elongated microcolumns each having an elongated central core of a first material positioned within an elongated outer tube of a second material. After the matrix material is cured, the polishing pad 22(a) can be exposed to a solvent that dissolves the microcolumn cores to produce the elongated cores 32 without dissolving the elongated outer support tubes 30. For example, such an elongated core 32 can be made using a crystalline carbon fiber as the central core, fiberglass as the elongated outer support tube 30, and concentrated sulfuric acid to dissolve the carbon fiber central core without dissolving the fiberglass support tube.

During the CMP process, the planarizing surface 28 of the polishing pad 22(a) becomes polluted with the material taken from the semiconductor wafers. As a result, the polishing pad 22(a) must be periodically conditioned by removing the planarizing surface 28 to expose a new planarizing surface. The substantially parallel orientation of the elongated microcolumns 24 ensures that the new planarizing surface exposed by the conditioning process is substantially identical to the old planarizing surface 28 before being polluted by the semiconductor wafer material. As a result, the polishing rate provided by the polishing pad 22(a) remains substantially constant throughout the life of the polishing pad 22(a).

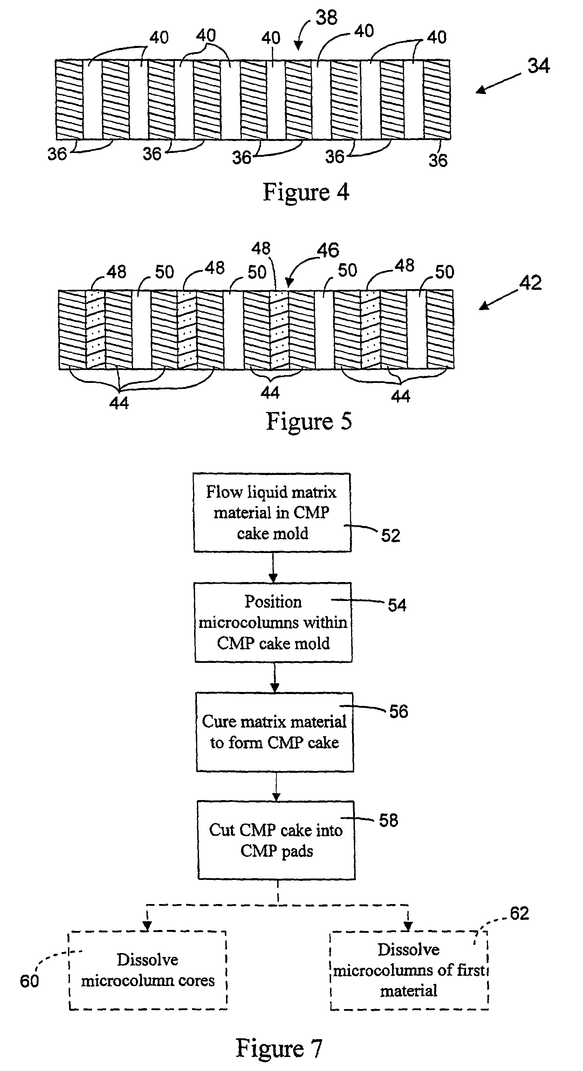

A cross-sectional view of a polishing pad 34 is shown in Figure 4. The polishing pad 34 includes a matrix material body 36 having a flat planarizing surface 38 for planarizing the semiconductor wafers. Extending perpendicularly from the planarizing surface 38 into the matrix material body 34 are a multiplicity of elongated pores 40. Like the elongated pores 32 shown in the embodiment of Figure 3, the elongated pores 40 enable liquid from the CMP process to extend into the elongated pores 40 when the polishing pad is used to planarize the semiconductor wafers. The elongated pores 40 can be created by embedding elongated microcolumns, like the elongated microcolumns 24 shown in Figures 2 and 3, into the matrix material 36 and then dissolving the elongated microcolumns with a solvent, such as hydrofluoric acid (HF). Embedding elongated microcolumns in the matrix material 36 ensures that the elongated pores 40 resulting from the dissolution of the elongated microcolumns are uniformly distributed. Such uniform distribution of elongated pores 40 results in the polishing pad 34 being uniformly porous, which helps ensure a constant polishing rate for the polishing pad. Accordingly, the polishing pad 34 is substantially identical to the polishing pad 22(a) shown in Figure 3 except that the polishing pad 34 does not retain the outer support tubes 30, and therefore, the polishing pad 34 is less rigid and more porous than the polishing pad 22(a).

A cross-sectional view of a third CMP polishing pad 42 is shown in Figure 5. The polishing pad 42 includes a matrix material body 44 having a flat planarizing surface 46 for planarizing semiconductor wafers. Extending inwardly from the planarizing surface 46 are a multiplicity of elongated microcolumns 48 interspersed with a multiplicity of elongated pores 50. Like the embodiment shown in Figure 3, the microcolumns 48 and the pores 50 preferably extend perpendicularly into the matrix material body 44 from the planarizing surface 46 such that the microcolumns 48 and the pores 50 are parallel to each other substantially along their entire lengths. The elongated microcolumns 48 and the elongated pores 50 are uniformly distributed throughout the polishing pad 42 such that the rigidity and porosity of the polishing pad remain constant throughout the life of the polishing pad.

The polishing pad 42 can be made by embedding two sets of microcolumns in the matrix material 44 with each set of microcolumns being made of a different material. After the matrix material is cured into the matrix material body 44, the polishing pad 42 can be subjected to a solvent that dissolves the first set of microcolumns to produce the elongated pores 50 without dissolving the second set of microcolumns 48 or the matrix material body 44. For example, if the microcolumns in the first set are made of carbon fiber, the microcolumns in the second set are made of fiberglass, and the polishing pad 42 is subjected to concentrated sulfuric acid, the carbon fibers will dissolve to produce the elongated pores 50 while the fiberglass microcolumns remain undissolved as the elongated microcolumns 48. Of course, those skilled in the art will understand that numerous materials can be used for the first and second sets of microcolumns and that numerous other solvents can be employed to selectively dissolve some of the microcolumns. In addition, the number of microcolumns in each set (of the two or more sets) could be varied as necessary to tailor the rigidity, porosity, and abrasiveness of the polishing pad 42 to the requirements of the CMP process being employed.

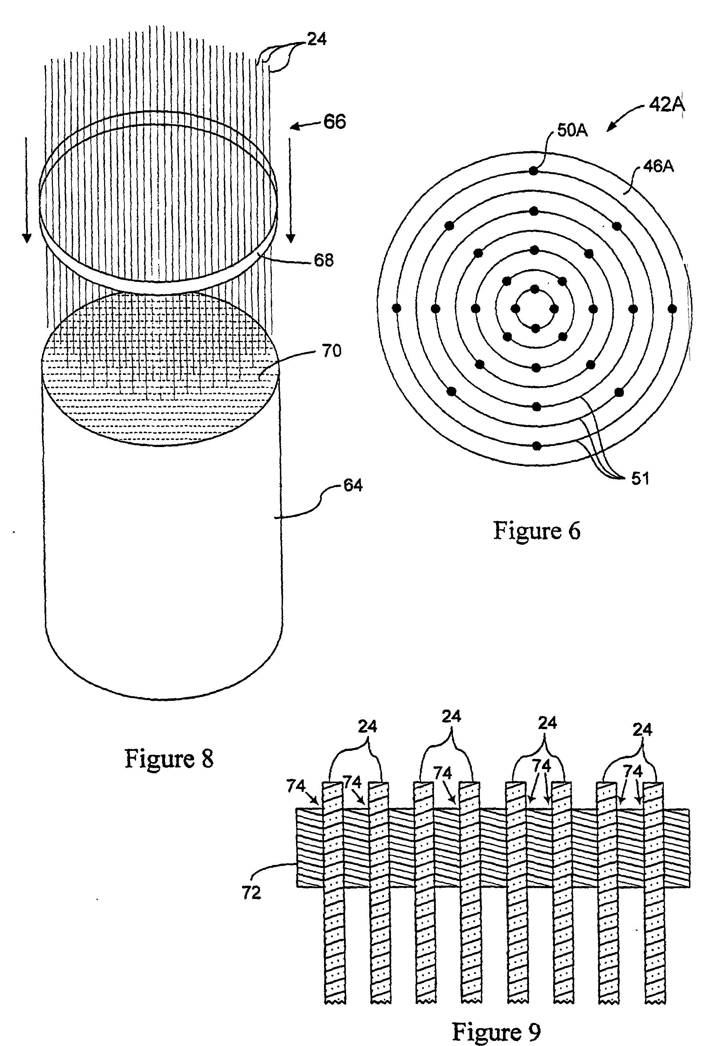

An elevational view of an alternate polishing pad 42A is shown in Figure 6. Like the polishing pads 22(a), 34, and 42 shown in Figures 3-5, the alternate polishing pad 42A includes a multiplicity of uniformly-spaced, elongated pores 50A. Further, the alternate polishing pad 42A includes a set of grooves 51 milled into a planarizing surface 46A of the alternate polishing pad. Each of the grooves 51 preferably is from 1 to 2000 microns deep and from 1 to 1000 microns in diameter. The grooves 51 shown in Figure 6 are concentric circles, but numerous other orientations can be employed such as concentric rectangles, parallel lines, etc. The grooves 51 enable the liquid used in the CMP process to travel between the elongated pores 50A and thereby increase the porosity of the alternate polishing pad 42A.

A flowchart of a method for making a CMP polishing pad is shown in Figure 6. The method includes flowing liquid matrix material into a CMP cake mold in step 52. In step 54 a plurality of elongated microcolumns are positioned within the CMP cake mold such that the liquid matrix material extends between and surrounds the microcolumns. It should be appreciated that the order of the steps 52 and 54 can be reversed so that the microcolumns are positioned in the mold first and then the liquid matrix material flows into the cake mold around the microcolumns. After the CMP cake mold is filled with the liquid matrix material and the microcolumns, the matrix material is cured to form a CMP polishing pad cake in step 56. After curing, the polishing pad cake is cut into a plurality of CMP polishing pads in step 58. If the elongated microcolumns positioned in the CMP cake mold in step 54 are already hollow as shown in Figure 3, then the polishing pad manufacturing process can end with step 58. Alternatively, the hollow microcolumns 24 can be made using elongated microcolumns with an elongated central core of a first material positioned within an elongated outer tube of a second material. If such two-part microcolumns are used, then in step 60 the polishing pad is exposed to a solvent to dissolve the microcolumn cores and thereby produce elongated pores 32 within the elongated outer support tubes 30 of the microcolumns 24.

A similar process can be used to create the polishing pad 42 shown in Figure 5. In step 54 the microcolumns positioned within the CMP cake mold would include a first set of microcolumns made of a first material interspersed with a second set of microcolumns made of a second material. After the matrix material is cured in step 56 and after the CMP cake is cut into polishing pads in step 58, the polishing pad can be exposed to a solvent material that removes the first material without removing the second material and the matrix material in step 62. Once again, carbon fibers, fiberglass fibers, and sulfuric acid may be used for the first material, second material, and solvent material, respectively.

Figure 8 illustrates one method for positioning the elongated microcolumns 24 within a CMP cake mold 64 according to step 54 (Figure 7). The elongated microcolumns 24 are coupled to each other as a bundle 66 using a connecting piece 68. Although the microcolumns 24 are shown spaced apart in Figure 8 for ease of illustration, the actual microcolumns 24 would be more closely bundled together. The bundle 66 of microcolumns is inserted into the cake mold 64 that already holds the liquid matrix material 70. After the bundle 66 is fully within the CMP cake mold 64, the connecting piece 68 can be removed and the matrix material is cured.

An alternate embodiment for positioning the elongated microcolumns 24 within the polymer pad cake mold 64 is to use an alignment fixture 72 having spaced apart apertures 74 through which the elongated microcolumns are passed as shown in Figure 9. Each elongated microcolumn 24 extends through a separate aperture 74 so that the microcolumns remain parallel to each other while the matrix material in the cake mold cures. Preferably, the alignment fixture 72 is mounted on the top of the CMP cake mold 64 so that the elongated microcolumns 24 extend through the apertures 74 directly into the CMP cake mold 64.

The many advantages of the present invention will be appreciated based on the foregoing discussion. In particular, by uniformly distributing the elongated microcolumns throughout a matrix material, the present invention provides a polishing pad having a constant polishing rate throughout the planarizing surface of the polishing pad. In addition, the uniform distribution of the elongated microcolumns enables the polishing pad to have a constant polishing rate throughout the life of the polishing pad. Furthermore, the ease of making each polishing pad with uniformly distributed microcolumns enables every polishing pad to exhibit substantially identical polishing characteristics. Conversely, the polishing characteristics can be altered easily and precisely from one polishing pad to another.

From the foregoing it will be appreciated that, although specific embodiments of the invention have been described herein for purposes of illustration. Accordingly, the invention is limited by the appended claims.

## Claims

1. A chemical-mechanical planarizing polishing pad (42) for planarizing semiconductor wafers, comprising:
a matrix body (44) having a planarizing surface (46) for planarizing the semiconductor wafers; and
a plurality of elongated solid microcolumns (48) positioned within the matrix body and extending inwardly from the planarizing surface, the microcolumns being substantially parallel to each other, distributed substantially uniformly throughout the matrix body, and abrasive relative to the semiconductor wafers, **characterized in that** said microcolumns (48) comprise non-hollow, solid microcolumns (48).

2. A chemical-mechanical planarizing polishing pad (42) for planarizing semiconductor wafers, comprising:
a matrix body (44) having a planarizing surface (46) for planarizing the semiconductor wafers; and
the matrix body having a multiplicity of parallel, uniformly spaced, elongated pores extending from the planarizing surface into the matrix body, the pores enabling liquid to extend into the pores when the polishing pad is used to planarize the semiconductor wafers; **characterized by**
a plurality of solid, elongated and non-hollow microcolumns extending inwardly from the planarizing surface between a plurality of elongated pores.

3. The polishing pad of claim 2 wherein the elongated pores extend substantially entirely through matrix body.

4. The polishing pad of claim 1 or 2 wherein the matrix body includes grooves in the planarizing surface that extend between the elongated pores.

5. The polishing pad of claim 1 or 2 wherein the matrix body is made of a polymeric material.

6. The polishing pad of claim 1 or 2 wherein the microcolumns include fiberclass.

7. The polishing pad of claim 1 or 2 wherein the microcolumns extend substantially entirely through the matrix body.

8. The polishing pad of claim 1 or 2 wherein the microcolumns are substantially perpendicular to the planarizing surface.

9. A method of making a chemical-mechanical planarizing polishing pad for planarizing semiconductor wafers, the method comprising:
positioning a plurality of parallel, elongated, solid microcolumns within a mold;
placing a liquid matrix material within the mold, the liquid matrix material extending between the microcolumns; and
curing the matrix material to form a pad body with the microcolumns interspersed within the cured matrix material and being abrasive relative to the semiconductor wafers, **characterised in that** non-hollow, solid microcolumns (48) are positioned within said mold.

10. The method of claim 9 wherein each microcolumn includes an elongated central core of a first material positioned within an elongated outer tube of a second material and the method further includes exposing the pad body to a material that removes the first material without removing the second material and the matrix material, creating elongated pores within the microcolumns.

11. The method of claim 9 wherein the microcolumns include a first set and a second set of microcolumns, the first and second sets being interspersed with respect to each other, the first set of microcolumns being made of a first material and the second set of microcolumns being made of a second material, and the method further includes exposing the pad body to a material that removes the first material without removing the second material and the matrix material, thereby creating elongated pores between the microcolumns of the seond set.

12. The method of claim 9 wherein the liquid matrix material is placed within the mold before the microcolumns are positioned within the mold.

13. The method of claim 9 wherein the microcolumns are coupled to each other by a connecting piece and the positioning step includes positioning the microcolumns within the mold as a bundle and the method further includes detaching the connecting piece from the microcolumns after the matrix material has cured.

14. The method of claim 9 wherein the positioning step includes maintaining the microcolumns spaced with respect to each other by extending the microcolumns through spaced-apart apertures in an alignment fixture, each microcolumn extending through a separate aperture of the spaced-apart apertures.

## Patentansprüche

1. Chemisch-mechanisch planarisierender, polierender Block (42) zum Planarisieren von Halbleiter-Wafern, aufweisend:
einen Matrixkörper (44) mit einer planarisierenden Oberfläche (46) zum Planarisieren der Halbleiter-Wafer; und
eine Mehrzahl von länglichen Feststoff-Micro-Säulen (48), die innerhalb des Matrixkörpers positioniert sind und die sich von der planarisierenden Oberfläche nach innen erstrecken, wobei die Micro-Säulen im wesentlichen parallel zueinander sind, im wesentlichen gleichmäßig über den Matrixkörper verteilt sind und schleifend bezüglich der Halbleiter-Wafer sind,
**dadurch gekennzeichnet, daß**
die Micro-Säulen (48) nicht-hohle, feste Micro-Säulen (48) aufweisen.

2. Chemisch-mechanisch planarisierender polierender Block (42) zum Planarisieren von Halbleiter-Wafern, aufweisend:
einen Matrixkörper (44) mit einer planarisierenden Oberfläche (46) zum Planarisieren der Halbleiter-Wafer; und
wobei der Matrixkörper eine Vielzahl von parallelen, gleichmäßig voneinander beabstandeten, länglichen Poren aufweist, die sich von der planarisierenden Fläche in den Matrixkörper erstrecken, wobei die Poren eine Flüssigkeit in die Lage versetzen, sich in die Poren zu erstrecken, wenn der polierende Block benutzt wird, um einen Halbleiter-Wafer zu planarisieren; **gekennzeichnet durch** eine Mehrzahl von festen, länglichen und nicht-hohlen Micro-Säulen, die sich von der planarisierenden Oberfläche zwischen einer Vielzahl von länglichen Poren nach innen erstrecken.

3. Polierender Block nach Anspruch 2, wobei sich die länglichen Poren im wesentlichen gänzlich durch den Matrixkörper erstrecken.

4. Polierender Block nach Anspruch 1 oder 2, wobei der Matrixkörper Nuten in der planarisierenden Oberfläche aufweist, die sich zwischen den länglichen Poren erstrecken.

5. Polierender Block nach Anspruch 1 oder 2, wobei der matrixförmige Körper aus einem Polymer-Material hergestellt ist.

6. Polierender Block nach Anspruch 1 oder 2, wobei die Micro-Säulen Faserglas aufweisen.

7. Polierender Block nach Anspruch 1 oder 2, wobei sich die Micro-Säulen im wesentlichen durch den ganzen Matrixkörper erstrecken.

8. Polierender Block nach Anspruch 1 oder 2, wobei die Micro-Säulen im wesentlichen rechtwinklig zu der planarisierenden Oberfläche sind.

9. Verfahren zum Herstellen eines chemisch-mechanisch planarisierenden, polierenden Blocks zum Planarisieren von Halbleiter-Wafern, wobei das Verfahren aufweist:
Positionieren einer Mehrzahl von parallelen länglichen Feststoff-Micro-Säulen innerhalb einer Form;
Plazieren eines flüssigen Matrixmaterials innerhalb der Form, wobei sich das flüssige Matrixmaterial zwischen den Micro-Säulen erstreckt; und
Härten des Matrixmaterials, um einen Block-Körper mit den Micro-Säulen zu bilden, die innerhalb des gehärteten Matrixmaterials eingefügt sind und schleifend bezüglich der Halbleiter-Wafer sind, **dadurch gekennzeichnet, daß** nicht-hohle Feststoff-Micro-Säulen innerhalb der Form positioniert sind.

10. Verfahren nach Anspruch 9, wobei jede Micro-Säule einen länglichen, zentralen Kern aus einem ersten Material aufweist, der innerhalb eines länglichen äußeren Rohrs aus einem zweiten Material positioniert ist, und bei dem Verfahren außerdem der Block-Körper einem Material ausgesetzt wird, welches das erste Material entfernt ohne das zweite Material und das Matrixmaterial zu entfernen, wobei längliche Poren innerhalb der Micro-Säulen erzeugt werden.

11. Verfahren nach Anspruch 9, wobei die Micro-Säulen eine erste Gruppe und eine zweite Gruppe von Micro-Säulen aufweisen, wobei die erste und die zweite Gruppe ineinander eingefügt sind, wobei die erste Gruppe von Micro-Säulen aus einem ersten Material hergestellt ist und die zweite Gruppe von Micro-Säulen aus einem zweiten Material hergestellt ist, und bei dem Verfahren außerdem der Block-Körper einem Material ausgesetzt wird, welches das erste Material entfernt ohne das zweite Material und das Matrixmaterial zu entfernen, wodurch längliche Poren zwischen den Micro-Säulen der zweiten Gruppe erzeugt werden.

12. Verfahren nach Anspruch 9, bei welchem das flüssige Matrixmaterial innerhalb der Form angeordnet wird, bevor die Micro-Säulen in der Form angeordnet werden.

13. Verfahren nach Anspruch 9, bei welchem die Micro-Säulen miteinander durch ein Verbindungsstück gekoppelt werden und im Rahmen des Positionierungsschritts die Micro-Säulen in der Form als ein Bündel positioniert werden, wobei das Verfahren weiterhin ein Abtrennen des Verbindungsstücks von den Micro-Säulen nach dem Härten des Matrixmaterials aufweist.

14. Verfahren nach Anspruch 9, bei welchem im Rahmen des Positionierschritts die Micro-Säulen voneinander beabstandet gehalten werden dadurch, daß sie die Micro-Säulen durch voneinander beabstandete Öffnungen in einer Ausrichtungsvorrichtung erstrecken, wobei sich jede Micro-Säulen durch eine separate Vorrichtung der voneinander beabstandeten Öffnungen erstreckt.

## Revendications

1. Tampon de polissage planarisation chimique et mécanique (42) pour planariser des pastilles de semi-conducteur, comprenant :
un corps de matrice (44) ayant une surface de planarisation (46) pour planariser les pastilles de semi-conducteur ; et
une pluralité de micro-colonnes solides allongées (48) positionnées à l'intérieur du corps de matrice et s'étendant vers l'intérieur à partir de la surface de planarisation, les micro-colonnes étant sensiblement parallèles les unes aux autres, distribuées de manière sensiblement uniforme dans le corps de matrice, et en relation abrasive avec les pastilles de semi-conducteur, **caractérisé en ce que** lesdites micro-colonnes (48) comprennent des micro-colonnes (48) solides non-creuses.

2. Tampon de polissage planarisation chimique et mécanique (42) pour planariser des pastilles de semi-conducteur, comprenant
un corps de matrice (44) ayant une surface de planarisation (46) pour planariser les pastilles de semi-conducteur ; et
le corps de matrice ayant une multiplicité de pores allongés, parallèles, uniformément espacés s'étendant à partir de la surface de planarisation dans le corps de matrice, les pores permettant à du liquide de s'étendre dans les pores quand le tampon de polissage est utilisé pour planariser les pastilles de semi-conducteur ; **caractérisé par**
une pluralité de micro-colonnes allongées, solides et non-creuses s'étendant vers l'intérieur à partir de la surface de planarisation entre une pluralité de pores allongés.

3. Tampon de polissage selon la revendication 2, dans lequel les pores allongés s'étendent sensiblement entièrement à travers le corps de matrice.

4. Tampon de polissage selon la revendication 1 ou 2, dans lequel le corps de matrice comprend des rainures dans la surface de planarisation qui s'étendent entre les pores allongés.

5. Tampon de polissage selon la revendication 1 ou 2, dans lequel le corps de matrice est fait d'un matériau polymère.

6. Tampon de polissage selon la revendication 1 ou 2, dans lequel les micro-colonnes comprennent un matériau fibreux.

7. Tampon de polissage selon la revendication 1 ou 2, dans lequel les micro-colonnes s'étendent sensiblement entièrement à travers le corps de matrice.

8. Tampon de polissage selon la revendication 1 ou 2, dans lequel les micro-colonnes sont sensiblement perpendiculaires à la surface de planarisation.

9. Procédé de fabrication d'un tampon de polissage planarisation chimique et mécanique (42) pour planariser des pastilles de semi-conducteur, le procédé comprenant :
positionner une pluralité de micro-colonnes allongées, parallèles, solides à l'intérieur d'un moule ;
placer un matériau de matrice liquide à l'intérieur du moule, le matériau de matrice liquide s'étendant entre les micro-colonnes ; et
figer le matériau de matrice pour former un corps de tampon avec les micro-colonnes disséminées à l'intérieur du matériau de matrice figé et
étant abrasives par rapport aux pastilles de semi-conducteur, **caractérisé en ce que** des micro-colonnes (48) solides non-creuses sont positionnées à l'intérieur dudit moule.

10. Procédé selon la revendication 9, dans lequel chaque micro-colonne comprend une âme centrale allongée en un premier matériau positionnée à l'intérieur d'un tube extérieur allongé en un second matériau et le procédé comprend en outre d'exposer le corps de tampon à un matériau qui enlève le premier matériau sans enlever le second matériau et le matériau de matrice, créant des pores allongés à l'intérieur des micro-colonnes.

11. Procédé selon la revendication 9, dans lequel les micro-colonnes comprennent une première série et une seconde série de micro-colonnes, les première et seconde séries étant intriquées l'une dans l'autre, la première série de micro-colonnes étant faite d'un premier matériau et la seconde série des micro-colonnes étant faite d'un second matériau, et le procédé comprend en outre l'étape consistant à exposer le corps de tampon à un matériau qui enlève le premier matériau sans enlever le second matériau et le matériau de matrice, créant ainsi des pores allongés entre les micro-colonnes de la seconde série.

12. Procédé selon la revendication 9, dans lequel le matériau de matrice liquide est placé à l'intérieur du moule avant de positionner les micro-colonnes à l'intérieur du moule.

13. Procédé selon la revendication 9, dans lequel les micro-colonnes sont couplées les unes aux autres par une pièce de connexion et l'étape de positionnement comprend l'étape consistant à positionner les micro-colonnes à l'intérieur du moule en un faisceau et le procédé comprend en outre l'étape consistant à détacher la pièce de connexion des micro-colonnes après que le matériau de matrice a figé.

14. Procédé selon la revendication 9, dans lequel l'étape de positionnement comprend l'étape consistant à maintenir les micro-colonnes espacées les unes des autres en étendant les micro-colonnes à travers des ouvertures espacées dans un appareillage d'alignement, chaque micro-colonne s'étendant à travers une ouverture séparée des ouvertures espacées.
